# EUROPÄISCHE PATENTSCHRIFT

(11) **EP 2 754 188 B1**
(45) Veröffentlichungstag und Bekanntmachung des Hinweises auf die Patenterteilung: **05.08.2015**
(21) Anmeldenummer: 12755859.1
(22) Anmeldetag: 04.09.2012
(51) Int. Cl.: H01L 41/45, H01L 41/047, H01L 41/083, H01L 41/27, H01L 41/293, H01L 41/297, H01L 41/331, H01L 41/193

(54) **ELASTOMERBESCHICHTUNGSKOPF MIT EINER BESCHICHTUNGSDÜSE UND VERWENDUNG VON AUFWEITMITTELN**
ELASTOMER COATING HEAD WITH A COATING NOZZLE AND USE OF EXPANDING MEANS
TÊTE DE REVÊTEMENT ÉLASTOMÈRE PRÉSENTANT UNE BUSE DE REVÊTEMENT ET EMPLOI DE MOYENS D'ÉVASEMENT

(30) Priorität: 06.09.2011 CH 14592011
(43) Veröffentlichungstag der Anmeldung: 16.07.2014
(73) Patentinhaber: EMPA Eidgenössische Materialprüfungs- und Forschungsanstalt, 8600 Dübendorf (CH)
(72) Erfinder: Kovacs, Gabor, CH-8165 Oberweningen (CH)
(74) Vertreter: Schneider Feldmann AG Patent- und Markenanwälte
(86) Internationale Anmeldenummer: PCT/EP2012/067221
(87) Internationale Veröffentlichungsnummer: WO 2013/034549

(56) Entgegenhaltungen:
- EP-A1- 0 629 114
- EP-A1- 1 887 026
- EP-A1- 1 919 072
- EP-A1- 2 284 933
- EP-A2- 2 323 188
- WO-A1-2005/086249
- WO-A1-2010/054014
- DE-A1- 2 423 373
- US-A- 5 143 805
- US-A1- 2007 116 858
- PUNNING A ET AL: "Multilayer dielectric elastomer actuators with ion implanted electrodes", SPIE PROCEEDINGS, THE INTERNATIONAL SOCIETY FOR OPTICAL ENGINEERING - SPIE, BELLINGHAM, WASHINGTON, USA, Bd. 7976, 7. März 2011 (2011-03-07), Seiten 79760U-1, XP002668832, ISSN: 0277-786X ISBN: 0-8194-2351-3
- "Bedienungsanleitung ZUA 2000 Universal-Applikator", , Nr. 2.1 8. Mai 2008 (2008-05-08), XP002686806, Gefunden im Internet: URL:http://www.zehntner.com/download/manua ls/manual_zua2000_d.pdf [gefunden am 2012-11-09]

## Beschreibung

### Technisches Gebiet

Die vorliegende Erfindung beschreibt einen Elastomerbeschichtungskopf mit einer Beschichtungsdüse, mittels welcher eine Elastomerschicht zur Formung einer Dielektrikumlage eines dielektrischen Elastomerstapelaktors bzw. -sensors aufbringbar ist und die Verwendung von Aufweitmitteln zur Aufweitung eines aus einer Düsenöffnung einer Beschichtungsdüse austretenden Materialstrahls eines Elastomers zur schichtweisen Erzeugung von Dielektrikumlagen eines dielektrischen Elastomerstapelaktors oder - sensors.

### Stand der Technik

Auf elektroaktiven Polymeren oder Elastomeren basierende Aktoren finden zunehmend Interesse in verschiedenen Bereichen der Technik, insbesondere im Automobilbau, der Robotik, der Optik und in der Medizintechnik. Erste kommerzielle Produkte sind in der Optik als Linsen zum Beispiel für Kameras in Handys zu finden. Aber auch die Entwicklung künstlicher Muskeln wird vorangetrieben.

Derartige dielektrische Elastomeraktoren (DEA) setzen elektrische Spannung in mechanische Arbeit um, so dass auch taktile Anwendungen, wie ein taktiler Handschuh oder eine taktile Anzeige für die Braille-Schrift (s. "Miniaturised Electrostatic Tactile Display with High Structural Compliance, M. Jungmann, H:F: Schlaak, in Proceedings of the Conference "Eurohaptics 2002") möglich sind.

Bekannte DEA bestehen aus mindestens einer Dielektrikumlage, bestehend aus einem inkompressiblen Elastomer in Form eines Films oder einer Folie, welches an jeweils einer Oberseite und einer Unterseite beidseitig mit Elektroden beschichtet ist. Beim Anlegen einer elektrischen Spannung an den Elektroden wird ein elektrostatisches Feld zwischen den Elektroden erzeugt, wodurch sich das Elastomermaterial aufgrund der Maxwell Spannung verformt. Bei der Verformung dehnt sich das Material senkrecht zur Feldrichtung aus und wird parallel zur Feldrichtung zusammen gepresst; eine Reduktion der angelegten Spannung bewirkt eine Rückkehr der Dielektrikumlage in seine ursprüngliche Konfiguration. Der dielektrische Elastomeraktor kann nun über den Verformungsweg des Elastomers Arbeit leisten.

Vorteilhaft an solchen dielektrischen Aktoren ist die hohe Energiedichte, die mehr als 0,2 J/cm3 betragen kann, was mehr als der doppelten Energiedichte von piezoelektrischen Aktoren entspricht. Weiter Vorteilhaft ist die Möglichkeit der Kapselung, so dass solche Aktoren je nach dem verwendeten Elastomer unter den verschiedensten Umgebungsbedingungen einsetzbar sind. Schliesslich sind die Materialkosten für solche Aktoren niedrig; sie sind zudem leicht und geräuschlos.

Der Struktur einer Kapazität entsprechend wirkt im dielektrischen Aktor das Elastomer als Dielektrikum, wobei eine möglichst hohe Dielektrizitätskonstante und möglichst hohe elektrische Durchschlagsfestigkeit angestrebt wird. Häufig werden Silikone oder Acryle verwendet, z.Bsp. das acrylische Elastomer VHB4910 von 3M, das grösste Dehnungen (bis 300%) zulässt. Eine mechanische Vordehnung des Elastomerfilms bzw. der Elastomerfolie führt zu erhöhter Durchschlagsfestigkeit und geringerer Dicke, was wiederum eine geringere Dicke des Films bzw. der Folie zur Folge hat und so zu tieferen elektrischen Spannungen für den gleichen elektrostatischen Druck. Bei Feldstärken bis zu 90 V/µm werden bei üblichen Elastomeren Dickendehnungen, d.h. Dehnungen in Feldrichtung, bis zu 20% erreicht.

Die Dicke einer Elastomerfolie liegt im µm - Bereich, z.Bsp. bei 60 µm bis 100 µm, wobei jedoch z.B. 20 µm wünschenswert wären, da bei dünneren Schichten eine kleinere elektrische Spannung für die gleiche Wirkung verwendet werden kann, was wiederum zu deutlich geringeren Kosten für die bei solchen Aktoren zu verwendenden Hochspannungsadapter führt.

Diese geringe Dicke ergibt auch bei hoch dehnbaren dielektrischen Schichten zwischen den Elektroden kaum einen nutzbaren Arbeitsbereich über die Dicke (oder Höhe) eines Aktors mit einem einzigen Paar von Elektroden. Zum Betrieb einschichtiger dielektrischer Elastomeraktoren werden Betriebsspannungen im Kilovoltbereich von 2kV bis etwa 20 kV benötigt. Derart hohe Betriebsspannungen liegen nahe an der Durchschlagfeldstärke des Elastomers und sind für viele Anwendungen störend.

Ein Ausweg wurde in der Entwicklung einer Mehrschichttechnologie und der Schaffung von mehrschichtigen dielektrischen Elastomeraktoren gefunden, welche dielektrische Elastomerstapelaktoren bilden. Entsprechend werden dielektrische Aktoren aus Stapeln von durch dielektrischen Schichten getrennten Elektrodenlagen gebildet, damit sich die Arbeitswege der einzelnen Elektrodenpaare addieren können, bis der resultierende Arbeitsweg über die Höhe des Stapels für eine Anwendung genügt (während die Arbeitskraft von der Fläche der Aktoren, und nicht von deren Anzahl abhängt).

Um DEAs in Mehrschichttechnologie anzufertigen, welche mit niedrigeren Betriebsspannungen betreibbar sind, wird eine Herstellung der einzelnen Dielektrikumlagen mit Lagendicken unterhalb von 100 µm, bevorzugt von wenigen Mikrometern angestrebt. Das Herstellungsverfahren muss automatisiert und damit kostengünstig ausgestaltet sein, welches eine reproduzierbare Herstellung der Dielektrikumlagen mit geringen Schwankungen der Dicken gewährleistet, womit mit verringerten Betriebsspannungen betätigbare dielektrische Elastomerstapelaktoren erreichbar sind. Angestrebt werden dielektrische Elastomerstapelaktoren mit bis zu hundert oder mehr Dielektrikumlagen, welche möglichst kostengünstig herstellbar sind.

Der Nachteil der mit verringerter Deformation dünneren Schichten verbundenen ist, wird durch Stapelung vieler Dielektrikumlagen ausgeglichen. Eine Mehrzahl von dünnen Dielektrikumlagen wird abwechselnd beidseitig mit Elektrodenlagen versehen und zu komplexen dielektrischen Elastomerstapelaktoren gestapelt. Die Anzahl der verwendeten Dielektrikumlagen kann an den gewünschten Verwendungszweck angepasst werden.

Aus dem Stand der Technik ist die schichtweise Erzeugung von Dielektrikumlagen durch Tauchen, Sprühen oder das Spin - Coating-Verfahren (Rotationsbeschichtungsverfahren) bekannt.

Das Rotationsbeschichtungsverfahren wird bei Umgebungsbedingungen durchgeführt und ist geeignet, dielektrische Elastomerstapelaktoren mit gewünschten Dicken der Dielektrikumlagen auf einem Schleuderteller schichtweise übereinander zu stapeln. Flüssiges Elastomer wird durch einen statischen Mischer auf ein Substrat auf dem Schleuderteller in einem ersten Dosierungsschritt durch Auftropfen aufgebracht, wobei der Schleuderteller eine geringe Drehzahl aufweist. Anschliessend wird in einem zweiten Abschleuderschritt mit erhöhter Drehzahl die Zentrifugalbeschleunigung zur Verteilung des Elastomers auf dem Substrat ausgenutzt. Es ist eine Dielektrikumlage mit kontrollierbarer Dicke ausbildbar. Je nach Viskosität des flüssigen Elastomers und der Geschwindigkeit des Schleudertellers wird die Dicke der resultierenden Dielektrikumlage definiert. Um reproduzierbare Dicken der resultierenden Dielektrikumlage zu erreichen muss die Viskosität konstant und die Drehzahl genau, am bestens computergesteuert, regelbar sein. Diese Elastomerbeschichtung läuft automatisiert ab.

Der Vorgang der Rotationsbeschichtung ist technisch gut beherrschbar und führt innerhalb von Minuten zu einer Dielektrikumlage mit der gewünschten Dicke. Der experimentelle Aufbau für den Schleudervorgang ist kompliziert, vor allem was die Steuerungseinheit des Schleudervorganges angeht, damit die geforderten Drehzahlen erreichbar sind.

Die erreichbare Homogenität und Oberflächenqualität wird durch die Ausbildung von sogenanntem Schattenwurf, Blasenbildung, unvollständiger Bedeckung der Substratoberfläche und Mitten- und/oder Randüberhöhungen gestört. Es ist keinesfalls trivial eine Vielzahl von Dielektrikumlagen bestehend aus einem Elastomer mit ausreichender Homogenität und geforderter Oberflächengüte in einem Verfahren mit möglichst wenig Ausschuss zu erreichen.

Aus der EP1919072 ist bekannt, dass die Herstellung einer Dielektrikumlage aus einem Elastomer mit Lagendicken von weniger als 100 µm nicht einfach ist, da derartige Elastomerlagen äusserst fein, empfindlich und elastisch aber auch plastisch verform- und dehnbar sind. Auch die gleichförmige Erstellung einer gewünschten Lagendicke und mit ausreichender Homogenität sind nicht einfach zu erreichen. Damit jede spätere Dielektrikumlage die gleiche Ausdehnungscharakteristik aufweist werden hohe Anforderungen an jede einzelne Dielektrikumlage gestellt.

Mit den aus dem Stand der Technik bekannten Düsen sind Elastomermengen in Form eines Kegels mit runder Ablagefläche ablegbar. Die erreichbare Homogenität der abgelegten Lagendicke ist nicht zufriedenstellend. Es wird unterschiedlich viel Elastomermaterial abgelegt, sodass eine ungleichmässige Lagendicke resultiert. Man muss nach dem Ablegen des Elastomermaterials eine ausreichende Zeit abwarten, damit sich das flüssige Elastomer aufgrund seiner Viskosität gleichmässig auf dem Substrat verteilt. Es können damit Dielektrikumlagen erreicht werden, die eine verbesserte Homogenität aufweisen. Dies kann nur durch eine zeitliche Verlängerung des Herstellungsprozesses erreicht werden, welche je nach Anzahl der anzufertigenden Dielektrikumlagen beträchtlich sein kann.

Bekannte Vorgehensweisen zur Aufbringung von Schichten werden in EP 0 629 114 A1 wird DE 24 23 373 beschrieben. Eine bekannte Suspension wird in EP 2 284 923 A1 beschrieben.

### Darstellung der Erfindung

Die vorliegende Erfindung wie durch Ansprüche 1 und 7 definiert hat sich zur Aufgabe gestellt die Herstellung von DEAs zu verbessern, wobei eine homogene reproduzierbare Verteilung des Elastomers mit einer definierten Lagendicke in kurzer Zeit ohne weiteren homogenisierenden Nachbehandlungsschritt der resultierenden Dielektrikumlage erreicht wird.

Dadurch, dass bei der Herstellung einer jeweiligen dielektrischen Schicht das im Wesentlichen flüssige Elastomer in der für die jeweilige Schicht vorbestimmten Dicke grossflächig und homogen direkt abgelegt wird, entfällt die Notwendigkeit der Rotation bzw. des Schleuderns für die Ausbildung sowohl der Schicht selbst als auch deren gewünschter Dicke, was die Produktionszeit erheblich verkürzt und die Produktionskosten erheblich senkt.

Ohne Rotation wiederum muss eine frisch ausgebildete Dielektrikumlage nur geringfügig soweit vernetzt werden, dass sie die ihr zugeordnete Elektrodenschicht tragen kann, da die erhebliche Beanspruchung durch die Rotation bei der Ausbildung der nächsten Schicht entfällt. Dadurch verkürzt sich die Produktionszeit zusätzlich.

Durch die genannte Ablage der dielektrischen Schichten wird eine Massenproduktion von schichtweise hergestellten Aktoren mit auch komplexem Aufbau möglich.

Die vorliegende Erfindung hat sich die Aufgabe gestellt eine Suspension zu schaffen, in welcher elektrisch leitfähige Partikel homogen und klumpenfrei gelöst sind, sodass sich beim Auftragen der Suspension homogene und klumpenfreie Elektrodenlagen ausbilden lassen. Dies ist zur Sicherstellung der elektrischen Leitfähigkeit der einzelnen Elektrodenlagen, der Überschlagssicherheit, der reproduzierbaren Herstellung sowie der Ansprechbarkeit des dielektrischen Elastomerstapelaktors besonders wichtig.

Eine weitere Aufgabe liegt in der vereinfachten Erstellung von Kontaktleitungen, welche ausschliesslich die jeweils ersten oder zweiten Elektrodenlagen miteinander verbinden, wobei eine Flexibilität der Kontaktleitungen erreicht wird.

### Kurze Beschreibung der Zeichnungen

Die Erfindung wird nachstehend anhand der Figuren näher erläutert.
- Figur 1a: zeigt einen Aufbau zum Aufbringen von Dielektrikumlagen aus Elastomeren mit einer Rastervorrichtung in einer schematischen perspektivischen Ansicht, während
- Figur 1b: eine Schnittansicht eines Aufbaus gemäss Figur 1a in y-Richtung und
- Figur 1c: eine Schnittansicht eines erzeugten quasi monolithischen dielektrischen Elastomerstapelaktors mit n = 11 Dielektrikumlagen und zwischenliegenden Elektrodenlagen zeigt.
- Figur 2a: zeigt einen Stapel eines hergestellten Aktors nach der Fertigstellung der ersten Dielektrikumlage, während
- Figur 2b: den Stapel des Aktors von Fig. 2a nach Fertigstellung der ersten Elektrodenlage und
- Figur 2c: den Stapel des Aktors von Fig. 2a nach Fertigstellung der zweiten Dielektrikumlage, jeweils in perspektivischer Ansicht zeigt.
- Figur 3: zeigt eine Schnittansicht eines erzeugten quasi monolithischen dielektrischen Elastomerstapelaktors mit n=11 Dielektrikumlagen und zwischenliegenden Elektrodenlagen, wobei eine Injektionsnadel, sowie ein erzeugter Verbindungskanal den Elastomerstapelaktor querend gezeigt sind, während
- Figur 4: einen Elastomerstapelaktor mit zwei Dielektrikumlagen perspektivisch zeigt, wobei Kontaktlaschen der ersten Elektrodenlage und der zweiten Elektrodenlage, zur Verbindung dargestellt sind, durch welche Verbindungskanäle gestochen werden.

### Beschreibung

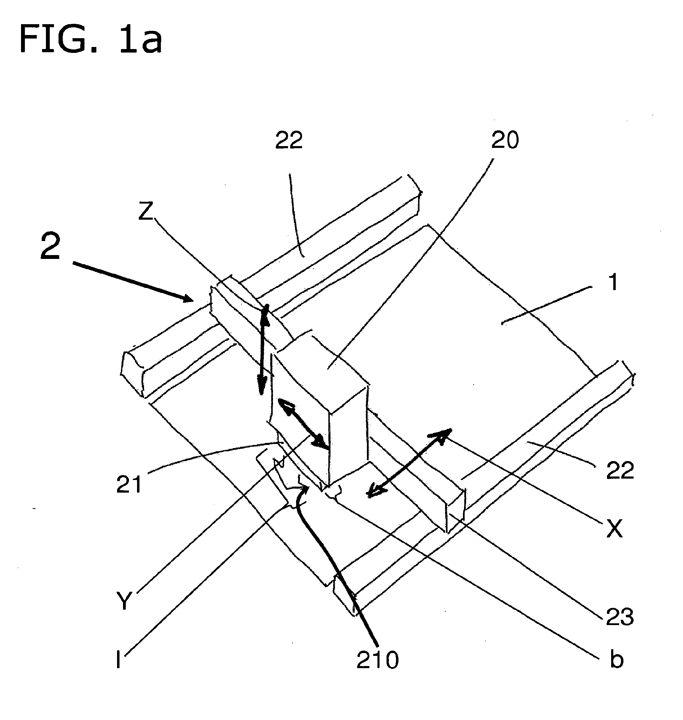

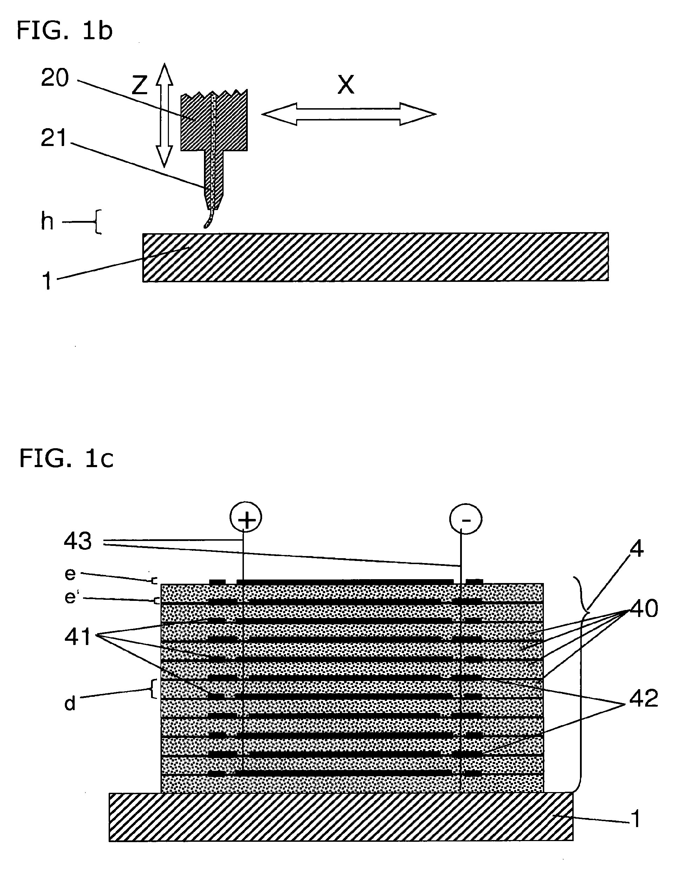

In Figur 1a ist eine Vorrichtung umfassend eine Substrathalterung 1 und eine Rastervorrichtung 2 schematisch perspektivisch dargestellt. Die Rastervorrichtung 2 umfasst hier zwei Längsschienen 22 und einen darin in der x-Richtung bewegbaren Querträger 23. Auf den Längsschienen 22 ist der Querträger 23 längs verfahrbar angeordnet.

Am Querträger 23 ist ein Elastomerbeschichtungskopf 20 als Ausbringeinheit befestigt, welcher in einer y-Richtung und einer z-Richtung relativ zum Querträger 23 bewegbar gelagert ist. Die x-, y-und z-Richtung sind orthogonal zueinander ausgerichtet. Ein Vorrats- bzw. Mischbehälter (nicht dargestellt) für auszubringendes flüssiges Elastomer ist im oder am Elastomerbeschichtungskopf 20 vorgesehen, aus welchem mindestens ein flüssiges Elastomer aus dem Elastomerbeschichtungskopf 20 abgebbar ist.

Durch eine Beschichtungsdüse 21 wird auf dem statisch gehaltenen Substrat ein Film aus flüssigem Elastomer abgelegt, wobei durch geeignetes Verfahren des Elastomerbeschichtungskopfes 20 zusammen mit der Ansteuerung der Beschichtungsdüse 21 eine beliebige Kontur in x- und y-Richtung der abgelegten Elastomerschicht erzeugt werden kann.

Mit einer nicht dargestellten Steuereinrichtung und Antriebseinrichtung ist der Elastomerbeschichtungskopf 20 in kontrollierten Höhen (in z-Richtung) über die örtlich fixierte Substrathalterung 1 reproduzierbar gesteuert führbar. Ohne, dass der Elastomerbeschichtungskopf 20 die Substratoberfläche berührt, kann das Elastomer berührungslos aufgebracht werden.

Weggelassen in der Figur 1a ist eine Bearbeitungsstation mit einer geeigneten Strahlungsquelle, wie beispielsweise eine IR - oder UV - Quelle zur Vernetzung der abgelegten Dielektrikumlagen 40, sowie eine weitere Bearbeitungsstation, in welcher Elektrodenlagen aufgebracht werden können.

Bevorzugt ist die Substrathalterung als mobile Unterlage ausgebildet, auf welcher der herzustellende Aktor der Rastervorrichtung 2 entnommen und zu einer UV -Quelle bzw. einer Station zur Aufbringung der Elektrodenschichten und schliesslich zur Vernetzung durch beispielsweise Wärmezufuhr (z.B. einem Ofen) und/oder Bestrahlung gebracht werden kann. Während des Aufbringens des flüssigen Elastomers und der Herstellung von Elektrodenlagen verbleibt das Substrat bevorzugt in Ruhe.

Am Elastomerbeschichtungskopf 20 ist die Beschichtungsdüse 21 befestigt, mittels welcher eine kontrollierte Menge des flüssigen Elastomers auf die Substrathalterung 1 bzw. auf die jeweils der Beschichtungsdüse 21 direkt zugewandten nächstliegende Substratoberfläche in zweidimensionaler Ausdehnung abgelegt werden kann. Die Beschichtungsdüse 21 weist Aufweitmittel auf, welche entweder an der Beschichtungsdüse 21 angeformt oder lösbar oder unlösbar befestigt sind. Durch die Aufweitmittel wird der austretende Materialstrahl gezielt in eine Richtung aufgeweitet. Hier ist die spezielle Gestaltung der Düsenöffnung so gewählt, dass ein gewünschtes Aufweiten erreicht wird.

Die hier dargestellte Beschichtungsdüse 21 weist eine schlitzförmige Düsenöffnung 210 auf. Dabei wird die Düsenöffnung 210 von einer Düsenöffnungslänge I, sich in y-Richtung erstreckend und einer Düsenöffnungsbreite b, in x-Richtung erstreckend, definiert. Dabei ist die Düsenöffnungslänge I um ein Vielfaches grösser gewählt als die Düsenöffnungsbreite b. Damit wird eine gewünschte gleichmässige Beschichtung bzw. ein Ablegen des viskosen flüssigen Elastomers auf das Substrat in nahezu zweidimensionaler Ausdehnung erreicht.

Durch das gerasterte Verfahren des Elastomerbeschichtungskopfes 20 ist das Elastomer streifenweise in x-Richtung aufgrund der festen Düsenöffnungsbreite b in Bahnen auslegbar, wobei die einzelnen Bahnen ebenfalls feste Breiten und eine im Wesentlichen konstante Dicke aufweisen, womit nach einer flächigen Bedeckung eine Dielektrikumlage 40 mit definierter Lagendicke d (siehe Fig. 1c) erreichbar ist.

Entscheidend ist die Ausgestaltung des Elastomerbeschichtungskopfes 20 mit Aufweitmitteln, die eine flächige nahezu zweidimensionale homogene Ablage von möglichst breiten Streifen des Elastomers erlauben. Der Materialstrahl des Elastomers muss dazu in definierten Höhen h flächig zweidimensional in einer Richtung (beispielsweise der Y-Richtung) verbreitert schichtweise ausgelegt bzw. abgelegt werden.

Dies kann neben einer oben beschriebenen schlitzförmigen Beschichtungsdüse 21 auch mit einer Düse mit kreisförmiger Öffnung, welche mit Aufweitmitteln wirkverbunden ist, geschehen. Als weiteres Aufweitmittel kann ein beabstandet angeordneter Trichter oder ein schräg angeordnetes Blech mit einer Aufweitung in y-Richtung dienen, auf welches das Elastomermaterial auftrifft und verteilt wird, bevor es auf das Substrat geleitet als verbreiterter Flüssigkeitsstrahl auftrifft.

Durch die Steuereinrichtung ist die gesteuerte Bewegung der Rastervorrichtung 2, des Elastomerbeschichtungskopfes 20 und damit der Beschichtungsdüse 21 in einer kontrollierbaren fixierten Höhe h (in z-Richtung) zur jeweils obersten Lage des Substrates erreichbar. Damit ist das Ablegen von Dielektrikumlagen 40 und die Bildung reproduzierbarer Lagendicken d möglich.

Wie in Figur 1c erkennbar weist ein fertiger DEA 4 eine sandwichStruktur aus erster Elektrodenlage 41, Dielektrikumlage 40 und zweiter Elektrodenlage 42 auf. Ein fertiger Elastomerstapelaktor 4 kann beidseitig Abschlussflächen in Form von Dielektrikumlagen 40 oder Abschlussflächen in Form jeweils einer Elektrodenlage 41, 42 aufweisen. Die Elektrodenlagen 41, 42 können auf verschiedene Arten auf der jeweiligen Dielektrikumlage 40 angeordnet werden. Die Elektrodenlagen 41, 42 umfassen elektrisch leitfähige Materialpartikel aus Metall oder Kohlenstoffpartikel. Dabei weisen die dargestellten Elektrodenlagen 41, 42 Elektrodenlagendicken e, e' auf. Nach dem schichtweisen Aufbau des dielektrischen Elastomerstapelaktors 4 erfolgt die Kontaktierung der ersten Elektrodenlagen 41 mit einer Anschlussleitung 43, getrennt von der Kontaktierung der zweiten Elektrodenlagen 42 mit Anschlussleitungen 43. Dadurch ist jede übernächste Elektrodenlage 41, 42 mittels Anschlussleitungen 43 an einen Pol einer Spannungsquelle anschliessbar.

Alle hier beschriebenen Verfahrensschritte laufen unter Reinraum- oder Reinstraumbedingungen und bei ortsfest gehaltener Substrathalterung 1 bzw. örtlich fixiertem ruhenden Substrat ab. Versuche haben gezeigt, dass die Reinraumbedingungen mindestens der Klasse 100 (US FED STD 209E) bzw. der Klasse ISO5 (ISO 14644-1) entsprechen sollten, um hochreine Lagen zu erzeugen. Die Raumtemperatur und der vorherrschende Luftdruck liegen üblicherweise im Bereich von 25°C und bei Atmosphärendruck. Entscheidend ist aber vor allem die Reinheit der Luft.

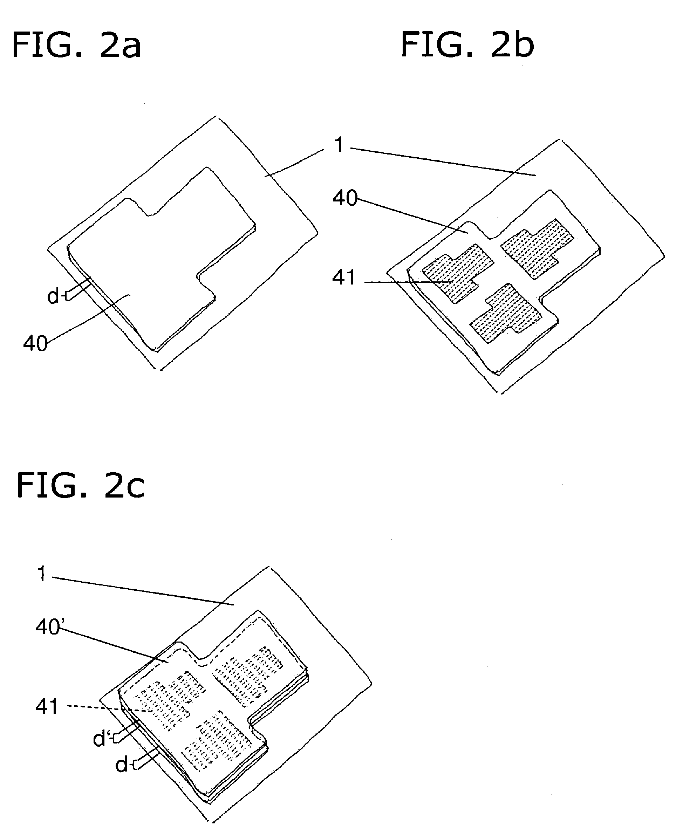

Figur 2a zeigt eine aus einem Elastomer gebildete erste Dielektriumlage 40 eines herzustellenden dielektrischen Elastomerstapelaktors 4 (Figur 1c), wie sie durch den Elastomerbeschichtungskopf 20 auf dem ruhenden Substrat abgelegt worden ist. Die erste Dielektriumlage 40 bleibt auf dem Substrat ohne Verschiebung so liegen, wie sie abgelegt worden ist - im Gegensatz zum spin coating - wird also statisch in der für die Schicht vorbestimmten Lagendicke d abgelegt. Durch Verwendung des Ablegens und der Aufweitmittel können die Dielektrikumlagen 40 gezielt in nahezu beliebig geformtem Grundriss aufgebracht werden.

Nachdem die Dielektriumlage 40 vollständig abgelegt ist, erfolgt ein Vernetzungsschritt, der mit unterschiedlichen Vernetzungsgraden durch eine thermische Behandlung in einem Ofen oder durch UV- oder Infrarotbestrahlung stattfinden kann.

Anschliessend wird wie in Figur 2b dargestellt eine erste Elektrodenlage 41 bzw. zweite Elektrodenlage mit einer Elektrodenlagendicke e aufgebracht. Sobald die Elektrodenlage 41, 42 aufgebracht ist, kann die Ablage einer weiteren Dielektrikumlage 40 wie in Figur 2c gezeigt erfolgen. Dieser Vorgang wird entsprechend einige dutzend bis hunderte von Malen wiederholt, wodurch ein Elastomerstapel wie in Figur 1c gezeigt erzeugt wird, welcher nach Kontaktierung von Anschlussleitungen 43 den fertigen dielektrischen Elastomerstapelaktor 4 bildet.

Als elektrisch leitfähige Materialpartikel kommen Kohlenstoffpartikel in unterschiedlichen Strukturformen in Frage, aber auch Metallpartikel. Verwendbare Materialpartikel weisen eine Grösse von weniger als einem Mikrometer auf. Als Elektrodenmaterial kann Graphitpulver, graphithaltige Paste oder leitfähiger Russ auf die jeweils vorab erzeugte Dielektrikumlage 40 bei Reinraumbedingungen aufgebracht werden. Es können neben Kohlenstoff-Nanoröhren Silber nano-wire und andere Materialpartikel mit Abmessungen kleiner als ein Mikrometer verwendet werden. Vorteilhaft ist die Verwendung von Materialpartikeln in Form von Nanopartikeln und damit Grössen von kleiner gleich 100 Nanometern.

Um die Elektrodenlagen 41, 42 aufzubringen werden die elektrisch leitfähigen Materialpartikel in einer Trägersuspension gelöst. Ein Flüssigkeitsstrahl der Trägersuspension mit darin gelösten Materialpartikeln wird mittels Piezoantrieb gesteuert, wobei zwischen tropfenweisem und strahlweisem Auslass gewählt werden kann. Durch die Steuerbarkeit unterschiedlich hoher Durchflüsse der Trägersuspension kann der Materialauftrag auf die gewünschte Vorschubgeschwindigkeit eingestellt werden.

### Beispiel:

Gute Ergebnisse homogener Dielektrikumlagen 40 mit geeigneter Lagendicke d wurden unter Verwendung einer Schlitzdüse 21 als Beschichtungsdüse 21 erreicht. Zur Erreichung von Lagendicken d der Dielektrikumlagen 40 von 40µm wurden die folgenden Parameter verwendet:
- Düsenöffnungslänge I der verwendeten Schlitzdüse 21: 40 mm
- Düsenöffnungsbreite b der verwendeten Schlitzdüse 21: 50µm
- Viskosität des Elastomers ( SEMICOSIL 945UV A/B von der Wacker Chemie AG): 1000 mPa.s
- Vorschubgeschwindigkeit des Elastomerbeschichtungskopfes 20 bzw. der Schlitzdüse 21 relativ zur Unterlage: 2 mm/s
- Höhe h der Düsenöffnung 210 von der jeweils der Schlitzdüse 21 direkt zugewandten Substratoberfläche: 60µm
- Durchfluss des Elastomers durch die Schlitzdüse 21: 3,2 µl/s

Bei Verwendung einer schlitzförmigen Beschichtungsdüse 21 sollte die Düsenöffnungslänge I wesentlich mindestens hundertmal grösser als deren Düsenöffnungsbreite ausgeführt sein.

Durch die Steuerung mittels Rastervorrichtung 2 kann Elastomermaterial in der Art eines Plotters auf das Substrat abgelegt werden. Damit dies exakt funktionieren kann muss die Auslassgeschwindigkeit des Elastomers auf die jeweilige Vorschubgeschwindigkeit angepasst sein. Optional kann eine Mehrzahl von Elastomerbeschichtungsköpfen 20 mit jeweils einer Beschichtungsdüse 21 an der Rastervorrichtung 2 befestigt sein, um die parallele gleichzeitige Herstellung einer Mehrzahl von Dielektrikumlagen 40 zu erreichen.

Als Elastomermaterial werden Silikone, 1- oder 2-Komponenten-Silikonkautschuke oder Acryle verwendet werden, welche entsprechend durch Bestrahlung und/oder thermische Energie vernetzen. Die Viskosität des verwendeten Elastomermaterials sollte bei kleiner gleich 1500 mPas liegen, damit ein ausreichend zügiges Aufbringen des Elastomermaterials durchführbar ist.

Durch geeignete Wahl der Parameter Abstand der Düsenöffnung 210 vom Substrat, Austrittsgeschwindigkeit des zu vergiessenden Elastomers und Vorschubgeschwindigkeit des Elastomerbeschichtungskopfes 20 lassen sich Dielektrikumlagen 40 mit einer Dicke von 30 µm oder weniger, bevorzugt mit einer Dicke zwischen 10 µm und 20 µm herstellen.

Generell ist es für die Bildung einer einwandfreien Schicht vorteilhaft, dass der Abstand der Düsenöffnung zur Unterlage im Bereich vom 1,5 fachen der Schichtdicke gehalten wird. Je nach der Viskosität des flüssigen Elastomers kann der Fachmann aber einen anderen Abstand vorsehen. Ebenso kann der Fachmann bei der Verwendung eines anderen Parameterwertes gegenüber den oben aufgelisteten Werten die restlichen Werte entsprechend einstellen.

Der hergestellte dielektrische Elastomerstapelaktor 4 kann auch als Sensor, oder auch als Aktor und Sensor gleichzeitig, eingesetzt werden, indem dessen Auswertelektronik, mit der er betriebsfähig verbunden ist, auf Grund eines aktuellen Verformungszustands des Aktors ein entsprechendes Signal generiert, welches geeignet ausgewertet werden kann. Dazu kann der Betriebsspannung des Aktors beispielsweise mit einer hochfrequenten Wechselspannung überlagert werden, wobei über diese eine der aktuellen Verformung des Aktors entsprechende Impedanz durch die Auswertelektronik detektierbar ist.

Nach dem Wissen der Anmelderin sind bisher solche mehrlagigen Systeme bestehend aus dünnen inkompressiblen Elastomerlagen mit einem Elastomerbeschichtungskopf 20, umfassend eine Bechichtungsdüse 21 mit Aufweitmitteln nicht verwendet worden. Derartige Anordnungen galten generell als ungeeignet. Lange Prozesszeiten, wie sie beim Ablegen von mehreren hundert bis mehreren tausend Dielektrikumlagen auftreten, haben bislang zum Einsatz von Rotationsbeschichtungsverfahren geführt.

### Suspension zur Herstellung der Elektrodenlagen

Zur Herstellung der elektrisch leitfähigen homogenen Elektrodenlagen 41, 42 wurde eine Suspension, umfassend einen Kolloidanteil elektrisch leitfähiger Materialpartikel, welche in einem wasserlöslichen Lösungsmittel dispergiert sind, verwendet, welche auf die Elastomeroberfläche gegeben wird.

Es wurden Karbon-Nano-Partikel unter der Bezeichnung "Ketjenblack 600" mir einem Lös ungsmittel vermischt, das SodiumDodecylBenzeneSulfonat ("SDBS") enthielt, um eine gleichförmige Verteilung der Karbon-Nano-Partikel in der resultierenden Suspension sicherzustellen. Zusätzlich wurde der Suspension Isopropanol hinzugefugt, um die Benetzbarkeit mit dem Aktormaterial sicher zu stellen.

Die Zubereitung dieser Suspension wurde wie folgt vorgenommen: 1g Ketjenblack 600 wurde in 125g Isopropanol und 2,5g SDBS gelöst. Dabei wurde das SDBS abgewogen, danach im Isopropanol im Ultraschallbad während ca. 5 bis 10 Minuten gelöst.

Die separat abgewogenen Kohlenstoffnanopartikel wurden danach zur Lösung im Ultraschallbad während weiteren mindestens 15 Minuten dazu gegeben.

Versuche haben gezeigt, dass ein Lösungsmittel umfassend Alkylbenzolsulfonate, insbesondere mindestens ein lineares Alkylbenzolsulfonat und insbesondere SodiumDodecylBenzeneSulfonat bzw. Natriumdodecylbenzolsulfonat umfassend zu besonders guten Ergebnissen führt.

Geeignete Suspensionen umfassten einen Kolloidanteil von 0.2 bis 2 Gew. %, einen Anteil des wasserlöslichen Lösungsmittels von 93 bis 98.8 Gew. % und einen Anteil des Additivs von 1 bis 5 Gew. %.

Neben elektrisch leitenden Partikel aus Kohlenstoff, beispielsweise Kohlenstoff-Nanoröhren, Kohlenstoff-Nanostäbe, Fullerene oder Graphen umfassende Partikel, können metallische Partikel in Form von metallischen Nanoröhren, Nanostäben oder Nanodrähten verwendet werden.

### Applikation der Suspension

Die Suspension wird in einem geschlossenen Behälter aufbewahrt, welches sich ausserhalb der Herstellanlage befindet. Unweit davon ist eine kommerziell erhältliches Dosierventil (Nordson EFD 781RC plus Backpack Ventilauslöser) auf der Herstellanlage angebracht, welches mit der Rastervorrichtung 2 in alle 3 Richtungen bewegt werden kann. Das System beinhaltet zudem eine Umwälzpumpe, welches die Suspension aus dem Behälter in das Dosierventil und wieder zurückpumpt, wodurch ein stetiger Fluss der Suspension in einem geschlossenen Kreislauf auch im ausgeschalteten (stand by) Zustand des Dosierventils aufrechterhalten wird. Diese andauernde Umwälzbewegung dient zur Vermeidung von Agglomeration sowie Sedimentation der Feststoffe (leitfähigen Partikel).

Während der Applikation der Elektrode wird die Düsenöffnung sehr nahe (ca. 50um) über der vorgängig aufgebrachten Dielektrikumlage 40 geführt. In dieser definierten Höhe über dem Substrat wird die Düsenöffnung in der Ebene (x-y-Richtung) bewegt, um die Suspension in einer gewünschten Form und Grösse aufzutragen.

Die grösstmögliche Düsenöffnung in Form einer Dosiernadel, bei welcher kein ungewolltes Nachtropfen erfolgt, hat einen Innendurchmesser von <= 0.41mm sowie eine Nadellänge von >=12.7mm. Dadurch ergibt sich eine maximale VorschubGeschwindigkeit der Düsenöffnung von bis zu 400mm/s. Hierbei beträgt der Volumenstrom der Suspension bis zu 8mm³/s.

Während dem Auftrag bildet sich zwischen Düsenöffnung und jeweiligem Substrat ein fortlaufender Tropfen, wobei ein Teil des Tropfens durch die Bewegung der Düsenöffnung auf der Oberfläche des Substrates liegen bleibt. Dadurch bildet sich eine ca. 10 - 20 µm dicke (nass) und 1mm breite Spur aus. Die Verteilung der Spur wird im Wesentlichen durch die Oberflächenspannung des Substrates sowie durch die Eigenschaft des verwendeten Lösungsmittels bestimmt.

Der Abstand der einzelnen Bahnen der abgelegten Suspension wird so gewählt, dass die nächste benachbarte Bahn die bereits abgelegte Bahn geringfügig überlappt (< 0.1 mm). Dadurch wird eine elektrische Verbindung zwischen den Bahnen geschaffen und gleichzeitig eine erneute Ablösung verhindert, welches zu einer leitfähigkeitsvermindernden Kraterbildung der bereits applizierten Elektrode führen würde. Spätestens 30 Sekunden nach dem Auftrag ist das Lösungsmittel verdampft (bei Raumtemeratur) und es verbleiben nur noch die leitfähigen Partikel auf dem Substrat zurück mit einer Schichtdicke <2µm. Durch eine wesentlich schnellere, z.B. durch lokale Erwärmung beschleunigte, Verdampfung bleiben die Partikel homogen auf der Oberfläche verteilt.

### Elektrisch leitende Verbindung der Elektrodenlagen

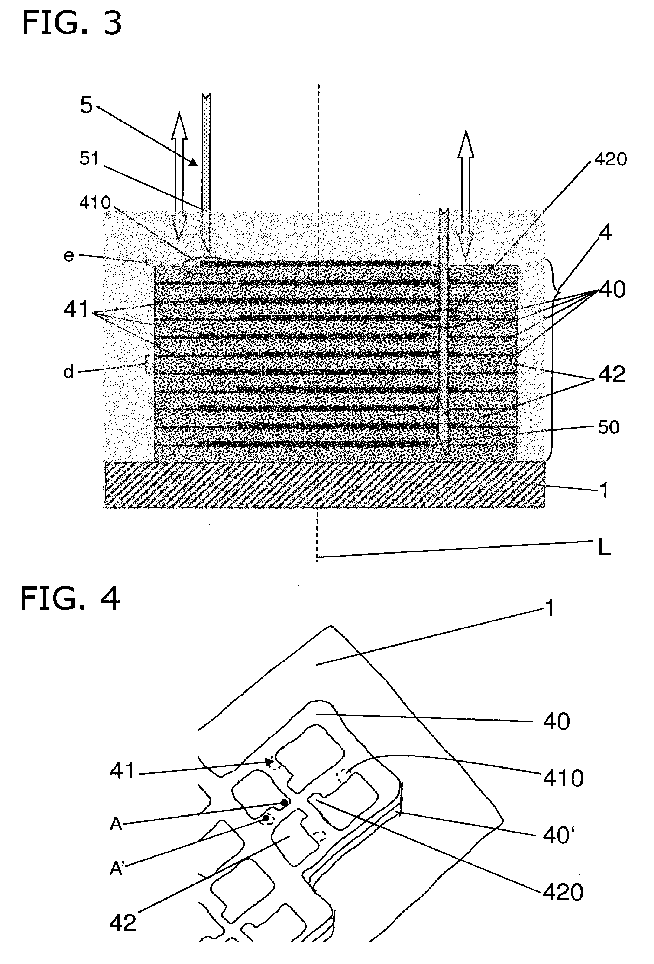

In einer speziellen Ausführungsform werden die elektrisch mit einander zu verbindenden Elektrodenlagen 41, 42 über eine durch den Körper des Stapels hindurch erfolgende Injektion aus leitendem Material 51 jeweils miteinander innerhalb des dielektrischen Elastomerstapelaktors 4 verbunden, was in Figur 3 gezeigt ist. Als zu injizierendes elektrisch leitendes Material kann eine Mischung aus elektrisch leitenden Partikeln gemischt mit einem Elastomer oder mit einem Lösungsmittel verwendet werden. Das leitende Material 51 wird je nach Art des leitenden Materials 51 nach der Injektion entweder vernetzt oder trocknet durch Verflüchtigung des Lösungsmittels.

Dadurch ergibt sich eine elektrische Verbindung zwischen den Elektrodenlagen 41, 42 die im Gegensatz zu den im Stand der Technik verwendeten starren Drähten beweglich ist, damit den durch den Betrieb bedingten Bewegungen des Aktormaterials folgen kann und so dessen Verschleiss verhindert und die Kontaktbedingung erhalten bleiben, was die Lebensdauer des Elastomerstapelaktors 4 erhöht. Wenn leitfähiges Material umfassend ein Elastomer verwendet wird, wird das injizierte Material vernetzt, wodurch flexible Zuleitungen resultieren.

Wie bereits erwähnt können elektrisch leitfähige Nanopartikel aus Kohlenstoff oder aus Metallen verwendet werden, welche mit einem Elastomer oder einem Lösungsmittel vermischt eine fliessfähige und damit injizierbare Suspension ergeben. Zur Herstellung von Verbindungskanälen 50 den Elastomerstapelaktor 4 querend zwischen den Elektrodenlagen 41, 42 unterschiedlicher Polarität verlaufend, wird eine Injektionsnadel 5 verwendet. In einem ersten Schritt wird der Elastomerstapelaktor 4 in Richtung Längsachse L etwa normal zur Ebene der Elektrodenlagen 41, 42 bzw. der Dielektrikumlagen 40 in Richtung Substrathalterung 1 durchstochen, womit Verbindungskanäle 50 den Elastomerstapelaktor 4 mindestens teilweise querend erzeugt werden.

Beim Herausziehen der Injektionsnadel 5, also der Entfernung von der Substrathalterung 1 wird das leitende Material 51 in die Verbindungskanäle 50 eingespritzt und damit die Verbindungskanäle 50 mit dem leitfähigen Material 51 verfüllt.

Die Erstellung von Verbindungskanälen 50, sowie das Verfüllen kann nach jedem Aufbringen einer weiteren oder mehreren Dielektrikumlagen 40 bzw. jeder weiteren oder mehreren Elektrodenlagen 41, 42 erfolgen, oder bevorzugt nach Fertigstellung des vollständigen dielektrischen Elastomerstapelaktors 4.

Die so zwischen den zugeordneten Elektrodenlagen 41, 42 gebildete elektrische Verbindung ist schlussendlich gesteigert elastisch beweglich, im Gegensatz zu dem im Stand der Technik üblichen Draht, dauerfest und schont damit das umgebende Material, was eine lange Lebensdauer des Aktors 4 unterstützt.

Wenn ein Lösungsmittel zur Bildung des leitenden Materials 51 verwendet wird, sollte das Lösungsmittel die leitfähigen Partikel als auch das Elastomer der Dielektrikumlagen 40 benetzen, um eine einwandfreie Funktion des in die Kanäle 50 verfüllten Materials 51, und damit des Elastomerstapelaktors 4 sicherzustellen. Nach dem Verdampfen des Lösungsmittels bzw. der Vernetzung des Gemisches aus Elastomer und leitfähigen Partikeln verbleibt eine flexibel bewegbare Verbindung, flexible Kontaktleitungen zwischen den ersten und zweiten Elektrodenlagen 41, 42, umfassend leitfähige Partikel innnerhalb der Verbindungskanäle 50 bestehen. Ausserhalb des dielektrischen Elastomerstapelaktors 4 werden die flexiblen Kontaktleitungen mit den externen Anschlussleitungen 43 verbunden, mittels welchen die Elektrodenlagen 41, 42 dann mit elektrischer Spannung beaufschlagbar sind.

Der resultierende dielektrische Elastomerstapelaktor 4 kann auch als Sensor oder als Aktor und Sensor gleichzeitig, eingesetzt werden, indem dessen Auswertelektronik, mit der er betriebsfähig verbunden ist, auf Grund eines aktuellen Verformungszustands des Elastomerstapelaktors 4 ein entsprechendes Signal generiert, welches geeignet ausgewertet werden kann. Dazu kann die Betriebsspannung des Aktors beispielsweise mit einer hochfrequenten Wechselspannung überlagert werden, wobei über diese eine der aktuellen Verformung des Aktors entsprechende Impedanz durch die Auswertelektronik detektierbar ist.

Um die Erzeugung von Verbindungskanälen 50, die spätere Injektion von leitfähigem Material 51 und das damit verbundene Auffüllen der Verbindungskanäle 50 derart durchführen zu können, dass jeweils alle ersten Elektrodenlagen 41 und zweite Elektrodenlagen 42 miteinander leitend verbindbar sind, müssen die Elektrodenlagen 41, 42 entsprechend ausgebildet sein. Wie in Figur 4 verdeutlicht, sind an den ersten Elektrodenlagen 41 Kontaktlaschen 410 und an den zweiten Elektrodenlagen 42 Kontaktlaschen 420 angeordnet. Beim Durchstechen der Injektionsnadel 5 senkrecht zur Substrathalterung 1 in Richtung der Längsachse L durch Durchstechpunkte A, A', welche in der Projektion in Richtung Längsachse L jeweils oberhalb der Kontaktlaschen 410 oder 420 liegen, sind somit Verbindungskanäle 50 erzeugbar, welche nur die gewünschte Kontaktlasche in jeder jeweils übernächsten Elektrodenlage durchstossen. Beim späteren Auffüllen der Verbindungskanäle 50 sind somit nur die gewünschten ersten oder zweiten Elektrodenlagen 41, 42 miteinander elektrisch leitend verbindbar.

Bevorzugt ist das leitende Material 51 ein mit leitenden Partikeln gefülltes Elastomer. Solche leitenden Partikel können aus Kohlenstoff bestehen oder auch metallisch sein. Insbesondere können die leitenden Partikel Graphenstrukturen, Kohlenstoff Nanoröhren, Kohlenstoff Nanostäbe oder metallischen Nanoröhren, Nanostäbe oder Nanodrähte aufweisen.

Eine Vermischung solcher Partikel mit einem unvernetzten Elastomer ergibt ein leitendes Material 51, welches eine fliessfähige und injizierbare Flüssigkeit bildet.

Besonders günstig ist es, wenn die leitenden Partikel ihrerseits aus demselben Material bestehen, durch welches die Elektrodenlagen 41, 42 gebildet sind und/oder das verwendete Elastomer dasselbe ist, wie es für die Dielektrikumlagen 40 verwendet wird um die Kompatibilität der Elektrodenlagen 41, 42 und den flexiblen Kontaktleitungen sicher zu stellen.

Neben der oben beschriebenen einstufigen Erstellung von Kontaktleitungen ist ein zweistufiger Vorgang möglich.

Beim einstufigen Prozess wird durch das Einstechen der bereits mit leitendem Material 51 gefüllten Injektionsnadel 5 in den Stapel ein Verbindungskanal 50 gebildet, wobei Material des dielektrischen Elastomerstapelaktors 4 verdrängt wird. Beim Herausziehen der Injektionsnadel 5 wird gleichzeitig das leitende Material 51 in den Verbindungskanal 50 injiziert. Der Verbindungskanal 50 verschliesst sich durch die verdrängungsbedingte mechanische Spannung soweit bis das Kanalvolumen der Abfüllmenge entspricht. So werden die durchtrennten Elektrodenlagen 41, 42 systembedingt im gesamten Kanalumfang an das leitende Material 51 angepresst was eine zuverlässige Kontaktierung zwischen leitendem Material 51 und Elektrodenlagen 41, 42 ergibt.

Beim zweistufigen Prozess wird in einem ersten Schritt mit einer Schneidnadel durch Einstechen und Durchstechen der Schneidnadel durch den dielektrischen Elastomerstapelaktor 4 Material aus diesem herausgetrennt, welches sich im Inneren der Schneidnadel ansammelt und beim anschliessenden Herausziehen der Schneidnadel aus dem Stapel entfernt wird. Im Gegensatz zum einstufigen Prozess bleibt hier der Verbindungskanal 50 nach der Erstellung geöffnet.

In einem anschliessenden Schritt wird das leitende Material 51 nach Einführen der Injektionsnadel 5 in den offenen Verbindungskanal beim anschliessenden Herausziehen in den Verbindungskanal abgefüllt. Die Abfüllmenge muss mindestens dem Kanalvolumen entsprechen dass eine zuverlässige Kontaktierung zwischen leitendem Material 51 und den Elektrodenlagen 41, 42 gegeben ist.

Sowohl bei der ein-, als auch der zweistufigen Methode wird im Anschluss an die Injektion das leitende Material 51 zum Beispiel durch Erwärmung vernetzt oder das Lösungsmittel abgedampft. Bei Verwendung des Elastomers als Teil des leitenden Materials 51 wird durch die Vernetzung eine mechanische Verbindung zwischen dem dielektrischen Elastomerstapel 4 und den flexiblen Kontaktleitungen erreicht.

### Implementierung:

Als leitendes Material 51 wird typischerweise ein mit Carbon Black gefülltes zweikomponentiges Silikonelastomer verwendet. Zur Anwendung kommen Wacker Elastosil RT 745, sowie Akzo Nobel Ketjenblack EC-600JD. Dieses vernetzt bei Raumtemperatur. Sowohl die Schneidnadel als auch die Injektionsnadel sind auf der Herstellanlage angebracht, welche mit der Rastervorrichtung 2 in alle 3 Richtungen im Raum bewegt werden können. Dadurch lassen sich die Verbindungskanäle 50 bzw. die flexiblen Kontaktleitungen mit höchster Präzision an der gewünschten Position anbringen.

Als Schneidnadel wird eine Biopsienadel aus dem Medizinalbereich verwendet. Diese hat einen Aussendurchmesser von 4 mm, Innendurchmesser von 3 mm und eine Länge von 125mm, wobei die Schneidnadel zur Erhöhung der Präzision gekürzt werden kann.

Die Schneidnadel wird mit einer Geschwindigkeit von bis zu 1 m/s in den dielektrischen Elastomerstapelaktor 4 gestochen. Dabei verformt sich dieser so dass je nach Materialeigenschaften ein kreisrunder Kanal mit einem Durchmesser < 1 mm ausgeschnitten wird.

Die Injektionsnadel 5 ist auf eine mit leitendem Material 51 gefüllte Kartusche aufgesetzt. Ein per Spindelmotor getriebener Kolben in der Kartusche kann das leitende Material 51 unter hohem Druck durch die Injektionsnadel 5 pumpen, was auch die Verarbeitung hochviskoser Flüssigkeiten bei Verwendung dünner Injektionsnadeln 5 zulässt. Typischerweise wird bei Verwendung eines leitenden Materials 51 umfassend mit leitfähigen Partikeln gefüllten Silikonelastomer mit einer Fliessviskosität > 10000 mPa s eine Injektionsnadel 5 mit 0.8 mm Innendurchmesser und einer Länge von 20 mm verwendet.

Bevorzugt wird die Erstellung der flexiblen Kontaktleitungen, nach der Herstellung des dielektrischen Elastomerstapelaktors 4 gemäss oben beschriebenen Verfahren und der Verwendung von Aufweitmitteln und/oder bei Verwendung einer Suspension zur Erzeugung von homogenen Elektrodenlagen wie beschrieben durchgeführt.

### Bezugszeichenliste

- 1: Substrathalterung
- 2: Rastervorrichtung
20 Elastomerbeschichtungskopf
21 Beschichtungsdüse
210 Düsenöffnung
l Düsenöffnungslänge
b Düsenöffnungsbreite
h Höhe der Beschichtungsdüse zur zu beschichtenden Oberfläche
22 Längsschiene
23 Querträger
- 4: dielektrische Elastomerstapelaktoren / EAP-Stapel
40 Dielektrikumlage (1 bis n)
d Lagendicke
41 erste Elektrodenlage/positiv
410 Kontaktlasche
42 zweite Elektrodenlage/negativ
e Elektrodenlagendicke
420 Kontaktlasche
43 Anschlussleitungen (Spannungsversorgung bzw. Sensorleitungen)
- 5: Injektionsnadel
50 Verbindungskanal
51 leitendes Material
A, A' Durchstechpunkt

## Patentansprüche

1. Verwendung von Aufweitmitteln zur Aufweitung eines aus einer Düsenöffnung (210) einer Beschichtungsdüse (21) austretenden Materialstrahls eines Elastomers zur schichtweisen Erzeugung von Dielektrikumlagen (40) eines dielektrischen Elastomerstapelaktors (4) oder - sensors, **dadurch gekennzeichnet, dass** der in eine y-Richtung aufgeweitete Materialstrahl auf einem Substrat, über welches die Beschichtungsdüse (21) mittels einer Rastervorrichtung (2) in einer x-Richtung bewegbar ist, ablegbar ist.

2. Verwendung gemäss Anspruch 1, wobei das Aufweitmittel eine schlitzförmige Düsenöffnung (210) der Beschichtungsdüse (21) ist, die eine Düsenöffnungslänge (1) die grösser als eine Düsenöffnungsbreite (b) ist, aufweist.

3. Verwendung gemäss Anspruch 2, wobei die Düsenöffnungslänge (1) mehr als hundertmal so gross ist wie die Düsenöffnungsbreite (b).

4. Verwendung gemäss Anspruch 2, wobei die Düsenöffnungslänge (1) im Bereich von 40 Millimetern und die Düsenöffnungsbreite (b) im Bereich von 50 Mikrometern liegt.

5. Verwendung gemäss Anspruch 1, wobei Aufweitmittel an die Beschichtungsdüse (21) von der Düsenöffnung (210) beabstandet oder abstandslos angeformt oder mit ihr lösbar oder unlösbar verbunden sind, sodass die Aufweitung des Materialstrahls in einer bevorzugten. Richtung (y) erreicht wird.

6. Verwendung gemäss Anspruch 1, wobei der Abstand der Düsenöffnung (210) zur Unterlage im Bereich des 1,5 fachen der abzulegenden Lagendicke (d) gehalten wird.

7. Suspension, umfassend einen Kolloidanteil elektrisch leitfähiger Materialpartikel, welche in einem wasserlöslichen Lösungsmittel dispergiert sind, zur Erstellung einer elektrisch leitfähigen homogenen Elektrodenlage (41, 42) auf einer Elastomeroberfläche einer Dielektrikumlage (40), **dadurch gekennzeichnet, dass** die Suspension 1 bis 5 Gew. % eines Additivs, umfassend Alkylbenzolsulfonate, umfasst.

8. Suspension gemäss Anspruch 7, wobei das Additiv ein lineares Alkylbenzolsulfonat ist.

9. Suspension gemäss Anspruch 7 oder 8, wobei das Additiv Natriumdodecylbenzolsulfonat ist.

10. Suspension gemäss einem der Ansprüche 7 bis 9, wobei der Kolloidanteil 0.2 bis 2 Gew. % , der Anteil des wasserlöslichen Lösungsmittels 93 bis 98.8 Gew. % und der Anteil des Additivs 1 bis 5 Gew. % beträgt.

## Claims

1. A use of expanding means for purposes of expanding a material jet of an elastomer exiting from a nozzle opening (210) of a coating nozzle (21), for the layer-by-layer generation of dielectric layers (40) of a dielectric elastomer stack actuator (4) or sensor, **characterised in that** the material jet expanded in a y-direction can be laid down on a substrate, over which the coating nozzle (21) can be moved in an x-direction by means of a rastering device (2).

2. The application in accordance with Claim 1, wherein the expanding means is a nozzle opening (210) of the coating nozzle (21) in the form of a slit, which has a nozzle opening length (1) that is larger than a nozzle opening width (b).

3. The application in accordance with Claim 2, wherein the nozzle opening length (1) is more than 100 times as large as the nozzle opening width (b).

4. The application in accordance with Claim 2, wherein the nozzle opening length (1) is of the order of 40 millimetres, and the nozzle opening width (b) is of the order of 50 microns.

5. The application in accordance with Claim 1, wherein expanding means on the coating nozzle (21) are spaced apart from the nozzle opening (210), or are moulded onto the latter without any spacing, or are detachably or non-detachably connected with the latter, such that the expansion of the material jet is achieved in a preferred direction (y).

6. The application in accordance with Claim 1, wherein the separation distance of the nozzle opening (210) from the base is maintained so as to be of the order of 1.5 times the layer thickness (d) to be laid down.

7. A suspension, comprising a colloidal component of electrically conductive material particles, which are dispersed in a water-soluble solvent, for purposes of creating an electrically conductive homogeneous electrode layer (41, 42) on an elastomer surface of a dielectric layer (40), **characterised in that** the suspension comprises 1 to 5 % by weight of an additive comprising alkyl benzene sulphonate.

8. The suspension in accordance with Claim 7, wherein the additive is a linear alkyl benzene sulphonate.

9. The suspension in accordance with Claim 7 or 8, wherein the additive is sodium dodecyl benzene sulphonate.

10. The suspension in accordance with one of the Claims 7 to 9, wherein the colloidal component is 0.2 to 2 % by weight, the component of the water-soluble solvent is 93 to 98.8 % by weight, and the component of the additive is 1 to 5 % by weight.

## Revendications

1. Utilisation de moyens d'évasement pour évaser un jet de matière d'un élastomère sortant d'une ouverture de buse (210) d'une buse de revêtement (21) pour la production, par couches, de couches diélectriques (40) d'un détecteur ou actionneur à empilement élastomère diélectrique (4), **caractérisée en ce que** le jet de matière évasé dans une direction y peut être déposé sur un substrat au-dessus duquel la buse de revêtement (21) peut être déplacée dans une direction x au moyen d'un dispositif à quadrillage (2).

2. Utilisation selon la revendication 1, dans laquelle le moyen d'évasement est une ouverture de buse (210) en forme de fente de la buse de revêtement (21), laquelle présente une longueur d'ouverture de buse (1) plus grande qu'une largeur d'ouverture de buse (b).

3. Utilisation selon la revendication 2, dans laquelle la longueur d'ouverture de buse (1) est plus de cent fois aussi importante que la largeur d'ouverture de buse (b).

4. Utilisation selon la revendication 2, dans laquelle la longueur d'ouverture de buse (1) se situe dans la plage de 40 millimètres, et la largeur d'ouverture de buse (b), dans la plage de 50 micromètres.

5. Utilisation selon la revendication 1, dans laquelle des moyens d'évasement sont formés sur la buse de revêtement (21), de manière espacée par rapport à l'ouverture de buse (210) ou de manière non espacée, ou bien sont reliés de manière détachable ou non détachable à celle-ci, de sorte que l'évasement du jet de matière est obtenu dans une direction (y) préférée.

6. Utilisation selon la revendication 1, dans laquelle l'espacement de l'ouverture de buse (210) par rapport à la base est maintenu dans la plage de 1,5 fois l'épaisseur de couche (d) à déposer.

7. Suspension comprenant une part colloïdale de particules de matière électroconductrice, lesquelles sont dispersées dans un solvant soluble dans l'eau pour la production d'une couche d'électrode (41, 42) homogène électroconductrice sur une surface d'élastomère d'une couche diélectrique (40), **caractérisée en ce que** la suspension comprend 1 à 5 % en poids d'un additif comprenant des alkylbenzènesulfonates.

8. Suspension selon la revendication 7, dans laquelle l'additif est un alkylbenzènesulfonate linéaire.

9. Suspension selon la revendication 7 ou 8, dans laquelle l'additif est du dodécylbenzènesulfonate de sodium.

10. Suspension selon l'une des revendications 7 à 9, dans laquelle la part colloïdale est de 0,2 à 2 % en poids, la part du solvant soluble dans l'eau étant de 93 à 98,8 % en poids et la part de l'additif, de 1 à 5 % en poids.
